(19) Europäisches Patentamt
European Patent Office
Office européen des brevets

(11) EP 4 700 382 A1

(12) EUROPEAN PATENT APPLICATION

(43) Date of publication:
25.02.2026 Bulletin 2026/09

(51) International Patent Classification (IPC):
*G01N 27/02* (2006.01)

(21) Application number: 25194057.3

(52) Cooperative Patent Classification (CPC):
G01N 27/025; G01N 27/08

(22) Date of filing: 05.08.2025

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 19.08.2024 US 202418808743

(71) Applicant: Georg Fischer Signet LLC
Irwindale, CA 91706 (US)

(72) Inventors:
• Salcedo, Jose
Pomona CA, 91767 (US)
• Bae, Sam
Placentia CA, 92870 (US)

(74) Representative: Li Schrag, Yue
Georg Fischer AG
Amsler-Laffon-Strasse 9
8201 Schaffhausen (CH)

(54) **TOROIDAL CONDUCTIVITY SENSOR**

(57) A toroidal conductivity sensor having increased range and linearity. The size of the driving coil can be reduced in comparison to the receiving coil. An internal conduction loop is provided through both driving and receiving coils.

*Fig-1*

EP 4 700 382 A1

**Description**

The present disclosure relates to conductivity sensors and, more particularly, to toroidal conductivity sensors.

BACKGROUND

This section provides background information related to the present disclosure which is not necessarily prior art.

Conductivity sensors are often used in industries such as pharmaceuticals, chemicals, food, metals, mining and a variety of other industries to measure the conductivities of various liquids. These conductivity sensors typically measure the resistance of the ionic liquid solution and use that measurement to measure conductivity.

Toroidal sensors are often used for this task. The sensors typically include two toroidal transformer coils that are spaced apart. One coil is usually called a drive coil or transmitter coil and the other coil is called a receiver coil or sense coil. When these toroidal sensors are immersed in a conductive fluid, the drive coil is electrically excited by an alternating current source and the drive coil generates a changing magnetic field.

This changing magnetic field induces a current loop in the fluid to be tested. The magnitude of the induced current is a function of the conductivity of the fluid. The current in the fluid induces a current in the receiver coil and that current is analyzed to measure the conductivity.

Among the disadvantages of the prior art toroidal sensors are problems with the linearization of the sensing signals; a limited sensing range, and a relatively bulky geometric size:

SUMMARY

This section provides a general summary of the disclosure and is not a comprehensive disclosure of its full scope or all of its features.

In accordance with the teachings of the present invention, techniques are provided to measure a wide range of conductivities.

Some of the advantages of the present invention are to:

1. Linearize the sensing signals.
2. Broaden the sensing range.
3. Provide a method to auto-calibrate the electronics before installation or for periodic auto-calibrations.
4. Decrease the geometric-size of proposed sensor.

A combination of the following aspects may be adopted:

1. Toroids having two different sizes in dimensions:

   a. It is not necessary to match permeances between the driving and the receiving cores.
   b. This means that one is free to use a smaller-sized core for the driver than for the receiver. This frees up volumetric space in the probe.
   c. This allows the Toroidal Probe to be geometrically smaller than previous models.

2. A resistive element with variable resistance, is connected in parallel with the receiving toroid.

   a. This variable resistive element value is selected based on the conductivity range and the conductivity of the medium.
   b. By changing the value of the resistive element the strength of the signal dependent on the current conductivity range can be changed.

3. An internal conduction-loop wound through both the driving and receiving cores. This conduction-loop has a variable resistor element.

   a. The resistor's resistance is chosen depending on the measured value of the medium.

An electric-field is induced in the media, through the toroidal probe's center. This electric-field drives an ionic current in the medium through the center of the hole. This electric field loops around the toroidal probe to close the ionic current. By changing the permeability and dimensions of the driving core it is possible to reduce the unwanted coupling between the two cores. This improves the signal resolution and reduces noise in the measured signal. This allows us to use an ideal inductance for each conductance range. This means that across the large dynamic conductivity range, we are measuring with an ideal inductance value for the Receiving Coil.

In convention, either two of the same permeances or permeabilities are used. The disadvantage of using this is that the range becomes narrower. For example, high permeance covers the lower conductive range, but low permeance covers the lower conductive range and vice versa. In other words, with high permeance, a maximum detectable signal is reached too quickly to miss out on the upper sensing range. See the governing equation below:

$$R_{h2o} = 2\pi f L_{cell} \left(\frac{N_R}{N_D}\right)\left(\frac{V_D}{V_R}\right)$$

Vd, driving voltage, is fixed. When the induced voltage, Vr, is too small or too large for the electronics to read. To keep Vr to be in the readable range, potentiometer is connected in parallel. When Vr becomes too small, a higher resistance value is used to increase the sensitivity of the measurement. In this fashion as the signal degrades in strength we can increase the resistance of the potentiometer to increase the strength of the signal. This is preferred to direct amplification, as direct amplification would amplify the noise as well.

In-situ calibration.

- The in-situ calibration enables calibration of the sensor without using external devices such as using decade boxes or calibrated solutions.
- To achieve this, a wire is looped through the driving and receiving toroids, and that is connected to the potentiometer like the one described above internally. This is packaged internally, along with the toroids.

The benefit is calibrating in-situ without taking the sensor outside to be paired with decade boxes or solutions.

Further areas of applicability will become apparent from the description provided herein. The description and specific examples in this summary are intended for purposes of illustration only and are not intended to limit the scope of the present disclosure.

BRIEF DESCRIPTION OF THE DRAWINGS

The drawings described herein are for illustrative purposes only of selected embodiments and not all possible implementations and are not intended to limit the scope of the present disclosure.

Fig. 1 is a perspective view of a conductivity sensor made in accordance with this invention;
Fig. 2 is a perspective view of the driving coil and receiving coil;
Fig. 3 is a circuit diagram for the drive circuit;
Fig. 4 is a circuit diagram for the receiving circuit;
Fig. 5 is a circuit diagram for the induction loop circuit; and
Fig. 6 is a circuit diagram showing the arrangement of the circuits of Figs. 3, 4 and 5 as used for measurements of characteristics of a fluid such as conductivity using the sensor.

Corresponding reference numerals indicate corresponding parts throughout the several views of the drawings.

DETAILED DESCRIPTION

Example embodiments will now be described more fully with reference to the accompanying drawings.

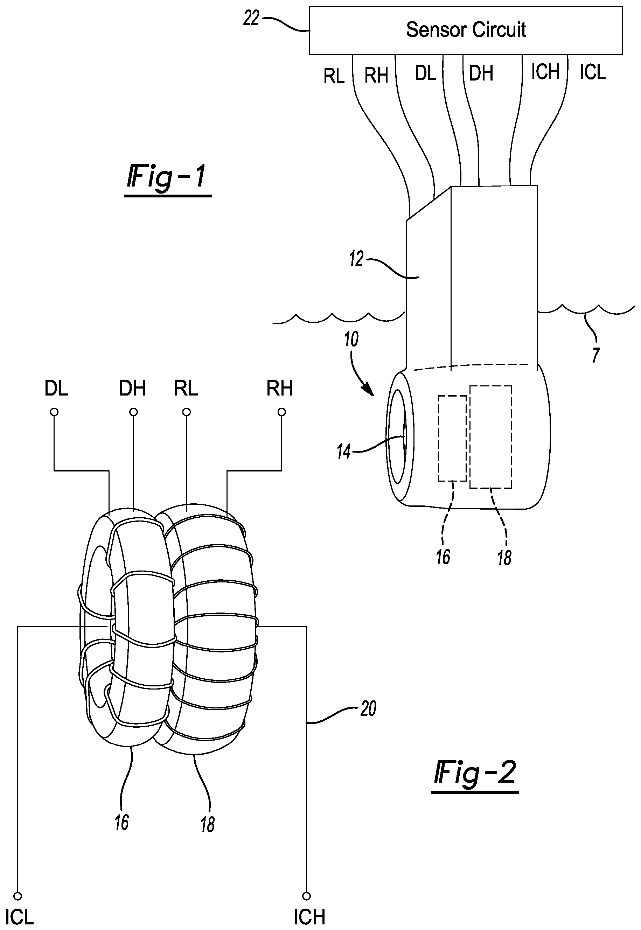

Turning now to Fig. 1, a conductivity sensor 10 is shown that is made in accordance with the teachings of this invention. Sensor 10 includes a nonconductive housing 12 made of plastic or the like. Housing 10 has a central bore 14 through which fluid F to be measured flows when the sensor 10 is immersed into the fluid. Surrounding the bore 14 is a driving coil 16 and a receiving coil 18.

As better shown in Fig. 2, the driving coil 16 has an annular magnetic core surrounded by a plurality of wires wrapped around the core in many loops through opening 17. The ends of the wires for the driving coil are labeled as DL and DH. Similarly, the receiving coil 18 is an annular magnetic core surrounded by a plurality of loops of wires passing through opening 19 terminating at ends RL and RH. As can be seen, the wires are looped around the cores through the apertures in the cores and around the outer circumference of the cores.

In addition, there is provided an internal conduction loop 20 that is a single wire wrapped around both receiving core and the driving core. The ends of the conduction loop 20 wire are labeled ICL and ICH. As best shown in Fig. 1, the internal conduction loop 20 is a wire in the housing 12 that loops through the opening 17 in the driving coil 16 and the opening 19 in the receiving coil 18 but is not exposed to the fluid F. In other words, it is internal to the housing 12 as shown most clearly in Fig. 1 and does not touch the fluid F.

The ends of the wires DL, DH, RL, RH, ICL and ICH are connected to sensor circuit 22 which may be internal or external to the housing 12.

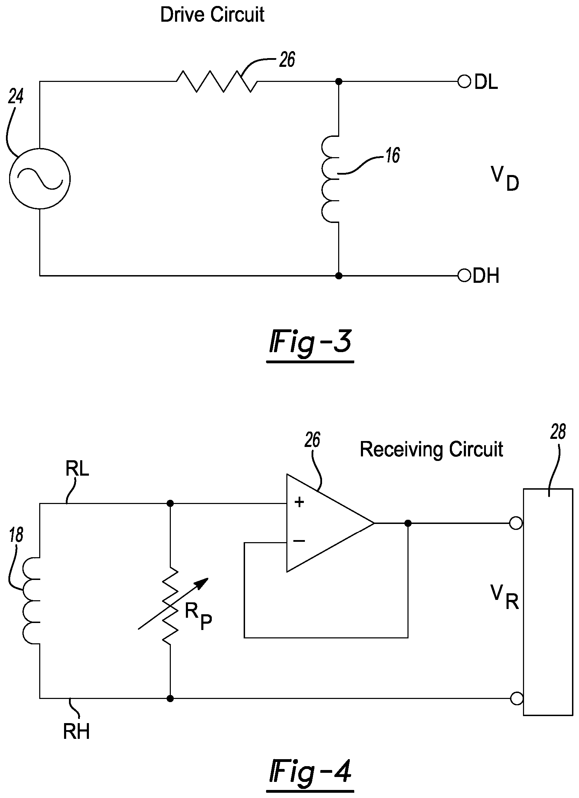

Fig. 3 Illustrates a drive circuit for drive coil 16. An alternating current source 24 creates a driving signal through resistor 26 that goes into the driving coil 16 in the housing 10. This will induce a signal not only in the fluid medium F but also in the internal conduction loop 20.

Fig. 4 shows a receiving circuit for the receiving coil 18. The receiving circuit includes a variable resistor RP connected across the receiving coil 18. This measured signal is connected to an op amp 27 which in turn is connected to suitable signal processing circuitry 28 that includes a filter and an analog to digital converter, as well as a processor.

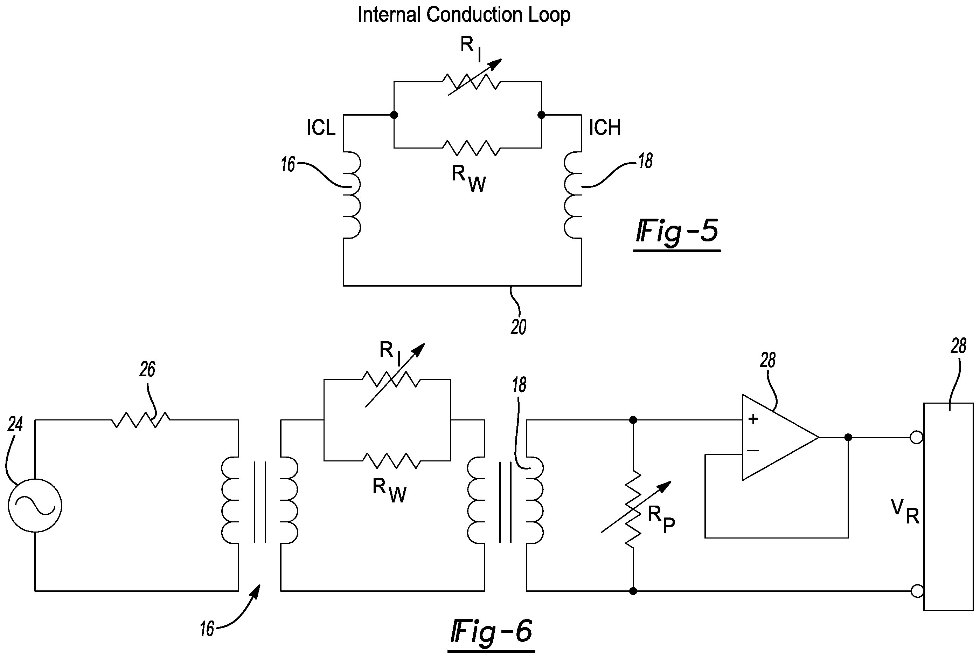

Fig. 5 shows circuitry for the internal conduction loop 20. The resistance RW represents the resistance of the fluid F, such as water. Connected in parallel to RW is a variable resistor RI whose purpose will be explained in detail later herein.

Fig. 6 shows the completed sensing circuit 22 including the drive circuit, receiving circuit, and internal conduction loop circuit.

Sensor 10 is sometimes called an Inductive Conductivity Sensor (ICS), which is a device to measure the conductivity of liquid media without direct contact to the media. This offers an advantage over Contacting Conductivity Sensors, called CCS hereafter, in harsher environments where the electrodes of the CCS would experience failures due to interactions with the harsher chemicals in the media, acids for examples. ICS such as Toroidal Sensors offer an advantage because they are not in direct contact with the media. CCS's tend to have the advantage in media with lower conductivity where the ICS have an advantage in media with higher conductivity. For these reasons ICS is the sensor of choice for higher conductivity media where the CCS is the sensor of choice for low conductivity media. The resilience to different media is a property to take advantage of in media with lower conductivity. This can be achieved by extending the measuring range of an ICS. This is done in several unique ways as described below.

There are toroidal ICS on the market that can measure a larger range, but they rely on a larger unit with larger power consumption and space requirements. These larger units can offer signal filters and measurement stabilization, increasing the range of the toroidal ICS. This does come at the cost of being bulky and power hungry. The aim with the following techniques is to create a Toroidal ICS that can offer the same dynamic large dynamic in a smaller package and with minimal power consumption. The goal is to create a sensor that uses primarily passive components to measure, and few of them. The signal conditioning is minimal. This will create an efficient sensor, that allows the physics of the measurement principles to provide a larger measuring range.

ICS's often have an error with accuracy across a large range. The method through which Toroidal ICS measure is susceptible to changes. This source of malleability of the measurement comes from the malleability of the relative magnetic permeability to various conditions, such as the current flowing around it. This value is dynamic with the conductivity of the medium. This means that ICS's tend to suffer from accuracy across a large range. A method to stabilize the measurement across a larger range is discussed herein.

In many operating environments, there is not often space to spare. In this regard if the sensor small - this is an advantage. A technique is also disclosed to reduce the size of the Driving-Coil to maximize space and measuring range. It is often desired to know if the electronics are correctly operating and are still within calibration. Described herein is a method that an ICS can carry calibration method internally with it.

The measuring range is dependent on the strength of the impedance of the Receiving-Coil 18 in relation to the impedance of the measured media F. This means that the relative strength of the signal goes in relation to the strength of the measuring range. One way to extend the measuring range would mean having circuits and filters to process signals of high dynamic ranges. Another method would be to change the strength of the Receiving-Coil inductance and as a result its impedance. This would change the ratio between the impedance of the medium and the impedance of the Receiving-Coil. Under normal circumstances this is not feasible for a small sensor to carry multiple cores. By pairing the Receiving-Coil 18 with a variable resistor RP (see Fig. 4) in parallel it is possible to change the effective inductance of the Receiving-Coil 18. Changing the effective Inductance of the Receiving-Coil 18 has the same effect on the measured signal as using a Receiving-Coil of different inductance value. This relation can be used to create stable signals across a larger range. This is done by "switching" to a different Receiving-Coil by adjusting RP when the measured signal becomes too weak.

Handling this larger dynamic range is currently done with amplifiers and filters. This does however have the effect of amplifying noise as well. There are filtering methods that can be used, but this space and components that hand-held sensors don't really have space or power to run. The present method to change the strength of the Receiving-Coil bypass this need by having one good measuring range and ensuring that the measured signal is always within this "golden zone" by changing the strength of the Receiving-Coil. This has the effect of only amplifying the measured signal and not the noise. This minimizes the needed electronics and power consumption while allowing this ICS to maintain the larger dynamic range of heavier desktop units.

As noted above, this can be achieved by connecting in parallel to the Receiving-Coil 18 a variable resistance element RP. The strength of the effective inductance of the Receiving-Coil 18 is dependent on the resistance of the parallel resistance element RP. What this means is that by changing the strength of the variable resistance element RP it is possible to change the effect inductance of the Receiving-Coil. This means that it is like having multiple cores in one.

By way of a specific example, when the fluid is in the range of 10 Ohms, then RP will be set to around 100 Ohms. This allows the general inductance of the receiving core to be on the order of 0.1uH. This is ideal for measuring the RW resistance range. When RW increases to around 100 Ohms, then RP will be on the order of 1000 Ohms. This leads to a receiving inductance on the order of 2uH., This is ideal for measuring RW on the order of 100 to 1000 Ohms. In this way, it is possible to have a receiving inductor with various inductance. This acts like having multiple cores on the toroidal sensor for measuring, and the user can switch to the ideal core for the current measuring range.

A measurement done with an ICS is dependent on the Relative Magnetic Permeability of the Receiving-Coil 18. The Relative Magnetic Permeability of the Receiving-Coil is dynamic and variable to various parameters. One parameter that is of interest is the current flowing around the Receiving-Coil. Because this value is dynamic the Magnetic Permeability of the Receiving-Coil is also somewhat dynamic. The total power flowing through the Receiving Coil 18 is fixed and cannot readily be increased. This means that there is power sharing that is occurring between the Receiving-Coil 18 and the Impedance of the medium F. This will lead to a non-linearity in the measurement. This can be understood as introducing inaccuracies to the measurement. According to the teachings of this invention to decrease the dynamic variability of the measurement is to artificially decrease the seen measured range, but not actually decrease the measuring range.

As can be seen in Fig. 1, the ICL 20 is an internal loop, internal to the housing 12. The ICL does not come in direct contact with the medium F ever. The ICL does, however, go through both the openings 17, 19 in Driving-Coil 16 and the Receiving-Coil 18. This ICL 20 imitates what happens in the medium F. In this configuration the sensor circuit 22 of sensor 10 sees a parallel resistance element RI that that is dependent not only on the conductivity of the medium F but also the resistance of the ICL 20.

This has the effect that the new resistance is an effective resistance created by the two current flows: the medium F ionic flow, and the ICL 20 current flow. The parallel effective resistance is always lower than either of the inputs. This means that the invention introduces artificial saturation points in order to decrease the dynamic variability of the measuring parameters. This creates a system that is accurate across larger ranges.

Assume that the fluid F resistance (RW) is in the range of 50K ohms, but the sensor can only measure up to 6K ohms. To eliminate this issue, if one is using a 50K ICL, then it can seen that the measured resistance will only be 4.545K-Ohms. This is fine, we took a water resistance that is outside of the measuring range 50K -Ohms and brought it into the measuring range. Using the correct values of IRL, we can ensure that we are always inside the measuring range, even though the resistance of the water might be well outside of the measuring range.

In portable units' space is not a luxury that is there. This is made worst for toroidal sensors where they must fit into a pipe through a small hole of predetermined size. This means that keeping geometry small is paramount to ensuring that the toroidal sensor will be usable in as many systems as possible. The sensitivity of the measurement is dependent on the strength or size of the Receiving Core but not the Driving Core. The Driving Core is only needed to generate a voltage. We just need to ensure that we can drive some voltage across the Driving Core. In order to maintain a large dynamic range, it is necessary to have a large enough Receiving-Coil, however, the Driving-Coil is not as important. If the inductor can generate the voltage with relatively low turns, then the Driving-Coil is allowed to be smaller. This allows for the ICS sensor to be smaller. As can be seen especially in Fig. 2 the coils have varying sizes where the driving coil 16 is much smaller than the Receiving-Coil 18 by at least 75% by volume. This creates the ideal scenario while reducing the size of the ICS. This means that the receiving core can be made larger, and still fit in the same volume. This will increase the measuring sensitivity of the probe by increasing the size of the Receiving Core while keeping the total size of the Torodial Sensor unchanged or even reduced.

It is possible to measure using a small drive coil as the only thing that is important when driving the toroidal is the voltage across the driving inductor coil. This means that the geometric size of the toroid is not as important. A larger permeability lowers the current required to drive the coil, but not the sensitivity of the sensor. We are able to use a smaller geometric size, as long as the driving voltage can be excited and the power consumption is acceptable.

It is often desired to know if the electronics are within calibration and are working correctly. The ICL with variable resistance elements (discussed above) allows a way to calibrate the electronics of an ICS. This can be done because the values of the variable resistance elements on the ICL are known. This allows a reference that the ICS can carry with it, this is a calibration that the ICS carries with it. With this reference, the electronics can be recalibrated after long use. This will allow the ICS to maintain its accuracy for longer. To calibrate the electronics this is done by removing the secondary ionic flow, flowing through the medium. This way there is only the current flow through the ICL. This allows the user to calibrate the electronics in sensor circuit 22 to the internal values.

By way of a specific example, the sensor circuit 22 can be calibrated using the ICL by removing the sensor 10 from the fluid or knowing the conductivity of the fluid F. The output of the sensor circuit 22 should be, for example, 100 when the sensor 10 is not in the fluid. But if the output instead reads 110, then suitable adjustments of the sensor circuitry 20 can be made, for example, by adding a calibration factor so that the sensor output reads 100.

In the previous sections it was explained how the total impedance is dependent on the cell inductance of the receiving core in a relation with the conductance of the medium. We can define a dimensionless constant to parameterize the relation, the parameterization variable we introduce is W

$$W \equiv \omega L_{\mathrm{Rcell}} L G_{h2o} \qquad (3.30)$$

The condition defined in the 3.29 can be expressed in terms of this dimensionless constant as

$$W = 1 \qquad (3.31)$$

Re-looking at the non-linear factor we found that the linear range is found when *factor* $\approx 1$, this can be re-expressed as

$$\omega L_{\mathrm{Rcell}} G_{h2o} << 1 \qquad (3.32)$$

Where now it can see as the conductance of the medium decreases at some point the above condition will be satisfied. If the above condition is satisfied then we are in the linear regime. Here the induced current is primarily effected by the impedance of the water.

$$I_{in} \approx -G_{h2o} \left( \frac{V_D}{N_D} \right) \qquad (3.33)$$

If we are not in the high resistance regime then we have to use the full expression for the induced current '

$$I'_{in} = \frac{-G_{h2o} V_D}{N_D (1 + \omega L_{cell} G_{h2o})} \qquad (3.34)$$

Equation 3.34 represents the current seen as a function of the medium conductance $G_{h2o}$ and of the cell inductance $L_{cell}$ which is not labelled as the inductance of the receiving core. As discussed below, there are 2 different values to consider when talking about the toroidal core. Here $L_{cell}$ is the inductance seen through the current loop. $L_{Rcell}$ is the value of the receiving cell that is directly used to measure and react to the magnetic flux. The value of $L_{Rcell}$ is calculated directly from $L_{cell}$, this will be discussed later in further detail. In the non-linear regime we can see that the both the sensitivity of the measurement as well as the linearity of the measurement suffer. In order to ensure that we are in the linear regime then we have to say that the receiving core has the cell-inductance satisfying

$$L_{\mathrm{Rcell}} << \frac{R_{h2o}}{\omega} \qquad (3.35)$$

The above expression allows us to see how the driving frequency affects the required receiving cell inductance, $L_{\mathrm{Rcell}}$ . For example if $\omega = 100000 rad$ then we need an $L_{Rcell} \approx 1 \times 10^{-5} H$. This seems to match what is seen in measurements where we use a receiving cell-inductance on the order of $L_{Rcell} \approx 1 \times 10^{-6} H$ to achieve linear results. As we'll see later though, this low receiving core inductance will cause errors in the high resistance range. This makes it so that one receiving core is not ideal for the entire dynamic measuring range.

With the methods described above it is possible to create an ICS that can measure across a large dynamic range. These methods allow the ICS to operate on low power using primarily passive components to make measurements. The ICS can have its size reduced using varying core sizes. By use of the ICL the dynamic variability of the measuring parameters can be minimized. The on-board reference resistance elements allow the ICS to maintain its accuracy for longer. Together these methods allow a more accurate, less power hungry, geometrically smaller, while maintaining the large measuring range expected of larger desktop units.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

**Claims**

1. A toroidal conductivity sensor comprising:

   a housing having an internal bore;
   a driving coil having a core with an aperture surrounded by loops of first wires;
   a receiving coil having a core with an aperture surrounded by loops of second wires;
   the driving coil and receiving coil being located in the housing and surrounding the bore; and
   sensor circuitry connected to the second and third wires, the sensor circuitry being configured to detect the conductivity of fluid flowing through the bore in the housing.

2. The conductivity sensor of claim 1 which further comprises:
   a variable resistor coupled in parallel between the receiving coil and the sensor circuity, configured to change the inductance of the receiving coil to increase the range and linearity of the sensor circuitry.

3. The conductivity sensor of claim 1 which further comprises:
   an internal conduction loop having a wire looped around both the driving coil and receiving coil, the internal conduction loop being located within the housing.

4. The conductivity sensor of claim 3 wherein the drive coil has an annular core with an opening and the receiving coil has an annular core with an opening, with the wire being looped through the openings of the driving coil and receiving coil while being contained within the housing and not exposed to the bore in the housing.

5. The conductivity sensor of claim 1 where the size of the driving coil is smaller than the size of the receiving coil.

6. The conductivity sensor of claim 5 where in the driving coil is smaller than the size of the receiving coil by at least 75% by volume.

7. The conductivity sensor of claim 3 wherein the internal conduction loop includes a variable resistor, configured to facilitate calibration of the sensor circuitry.

8. A method of measuring conductivity of a fluid with a toroidal conductivity sensor, the sensor having an internal bore, a driving coil with a core with an opening surrounded by loops of first wires, a receiving coil having a core with an opening surrounded by loops of second wires, the driving coil and receiving coil being located in the housing and surrounding the bore, the sensor further including sensor circuitry for measuring conductivity of the fluid, said method comprising:

   coupling a variable resistor between the receiving coil and sensor circuitry; and
   adjusting the variable resistor to change the inductance of the receiving coil to increase the range and linearity of the sensor circuitry.

9. The method of claim 8 wherein:

   if the fluid is in the range of 10 ohms then the variable resistor is set to about 100 ohms resulting in an effective inductance of the receiving coil of about 0.1uH; and
   if the fluid is in the range of 100 ohms then the variable resistor is set to about 1000 ohms resulting in an effective inductance of the receiving coil of about 2uH.

10. The method of claim 9 which further comprises:
    providing a drive coil which is smaller than the receiving coil.

11. A method of measuring conductivity of a fluid with a toroidal conductivity sensor, the sensor having an internal bore, a driving coil with a core with an opening surrounded by loops of first wires, a receiving coil having a core with an opening surrounded by loops of second wires, the driving coil and receiving coil being located in the housing and surrounding the bore, the sensor further including sensor circuitry for measuring conductivity of the fluid, said method comprising:
    providing an internal conduction loop having a wire looped around both the driving coil and receiving coil, the internal conduction loop being located within the housing.

12. The method of claim 11 wherein the drive coil has an annular core with an opening and the receiving coil has an annular core with an opening, with the wire being looped through the openings of the driving coil and receiving coil while being contained within the housing and not exposed to the bore in the housing.

13. The method of claim 12 wherein the internal conduction loop is used to calibrate the sensor circuitry.

14. The method of claim 13 wherein the internal conduction loop further includes a variable resistor which is adjusted to facilitate calibration.

_Fig-1_

Sensor Circuit

22

RL | RH | DL | DH | ICH | ICL

12

10

7

14

16  18

_Fig-2_

DL   DH   RL   RH

16   18

20

ICL                    ICH

Drive Circuit

$$Fig-3$$

Receiving Circuit

$$Fig-4$$

Internal Conduction Loop

_Fig-5_

_Fig-6_

EP 4 700 382 A1

## EUROPEAN SEARCH REPORT

**Application Number**

EP 25 19 4057

### DOCUMENTS CONSIDERED TO BE RELEVANT

| Category | Citation of document with indication, where appropriate, of relevant passages | Relevant to claim |
|---|---|---|
| X | US 6 414 493 B1 (REZVANI BEHZAD [US]) 2 July 2002 (2002-07-02) * figures 1-5 * * column 1, line 45 - column 4, line 13 * ----- | 1-4,7, 11-14 |
| X | CN 114 858 867 A (NAT OCEAN TECHNOLOGY CT) 5 August 2022 (2022-08-05) * the whole document * ----- | 1-4,7-9, 11-14 |
| X | US 3 030 573 A (HIROMN YAMASHITA ET AL) 17 April 1962 (1962-04-17) * figures 1-3 * * column 1, line 24 - column 3, line 46 * ----- | 1-14 |

**CLASSIFICATION OF THE APPLICATION (IPC)**

INV.
G01N27/02

**TECHNICAL FIELDS SEARCHED (IPC)**

G01N

The present search report has been drawn up for all claims

| Place of search | Date of completion of the search | Examiner |
|---|---|---|
| Munich | 18 December 2025 | Colasanti, Katharina |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...............................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 19 4057

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2025

| Patent document cited in search report | | Publication date | Patent family member(s) | Publication date |
|---|---|---|---|---|
| US 6414493 | B1 | 02-07-2002 | NONE | |
| CN 114858867 | A | 05-08-2022 | NONE | |
| US 3030573 | A | 17-04-1962 | NONE | |

EPO FORM P0459

For more details about this annex : see Official Journal of the European Patent Office, No. 12/82